# EUROPÄISCHE PATENTSCHRIFT

(11) **EP 1 021 593 B1**
(45) Veröffentlichungstag und Bekanntmachung des Hinweises auf die Patenterteilung: **05.12.2001**
(21) Anmeldenummer: 98961004.3
(22) Anmeldetag: 05.10.1998
(51) Int. Cl.: C23C 18/42

(54) **VERFAHREN UND LÖSUNG ZUR HERSTELLUNG VON GOLDSCHICHTEN**
METHOD AND SOLUTION FOR PRODUCING GOLD COATINGS
PROCEDE ET SOLUTION POUR PRODUIRE DES COUCHES D'OR

(30) Priorität: 08.10.1997 DE 19745602
(43) Veröffentlichungstag der Anmeldung: 26.07.2000
(73) Patentinhaber: ATOTECH Deutschland GmbH, 10553 Berlin (DE)
(72) Erfinder: BACKUS, Petra, D-10777 Berlin (DE); MAHLKOW, Hartmut, D-12159 Berlin (DE); WUNDERLICH, Christian, D-16727 Velten (DE)
(74) Vertreter: Effert, Bressel und Kollegen
(86) Internationale Anmeldenummer: DE9803007
(87) Internationale Veröffentlichungsnummer: WO9918253

(56) Entgegenhaltungen:
- DE-C- 4 202 842
- GB-A- 872 785
- US-A- 5 206 055
- PATENT ABSTRACTS OF JAPAN vol. 097, no. 010, 31. Oktober 1997 & JP 09 157859 A (HITACHI CHEM CO LTD), 17. Juni 1997

## Beschreibung

Die Erfindung betrifft ein Verfahren und eine Lösung zur Herstellung von Goldschichten.

Zur Herstellung löt-, kleb- und bondfähiger Oberflächen an Leiterplatten und anderen elektronischen Bauteilen sowie zur Erzeugung von elektrischen Kontakten werden Goldschichten eingesetzt. Diese wurden anfangs auf elektrolytischem Wege hergestellt. Jedoch weisen die Verfahren, bei denen die elektrolytische Goldabscheidung eingesetzt werden kann, erhebliche Nachteile auf. In vielen Fällen kann Gold gar nicht elektrolytisch abgeschieden werden, da elektrisch voneinander isolierte Flächen vergoldet werden müssen.

Daher wurden stromlose Verfahren entwickelt, bei denen Gold ohne äußere elektrische Kontaktierung aus einer geeigneten Lösung aufgebracht werden kann. Bei derartigen Verfahren eingesetzte Bäder werden insbesondere bei der Herstellung hochwertiger Leiterplatten oder von Schaltungsträgern für integrierte Schaltkreise eingesetzt. Üblicherweise wird die für den Lötprozeß benötigte Endschicht aus stromlos abgeschiedenem Nickel oder einer Nickellegierung und einer darauf abgeschiedenen dünnen Goldschicht gebildet. Die Gold-schichtdicke beträgt nur 0,05 µm bis 0,2 µm. Dünnere Schichten können das darunterliegende Nickel nicht mehr ausreichend schützen. Ohne nachhaltige Schädigung der Nickelschichten können andererseits auch keine dickeren Schichten abgeschieden werden.

Lösungen zur stromlosen Abscheidung enthalten unter anderem Reduktionsmittel, beispielsweise Ascorbinsäure, Hydrazin, Hydroxylamin, Dimethylamino-, Trimethylaminoboran oder Formaldehyd. Auch Thioharnstoff und dessen Derivate werden als Reduktionsmittel vorgeschlagen.

Diese Lösungen enthalten als Goldsalze Komplexverbindungen, beispielsweise Halogeno-, Cyano-, Thiosulfato- oder Sulfitokomplexe.

In US-A-52 02 151 wird ein Verfahren zum stromlosen Abscheiden von Gold beschrieben, bei dem Gold(I)-lonen-Komplexe von Thiosulfat oder Sulfit und als Reduktionsmittel Thioharnstoff, dessen Derivate oder Hydrochinon verwendet werden. Der Lösung kann zur Stabilisierung außerdem zusätzlich Sulfit zugegeben werden. Der pH-Wert der Lösung liegt im Bereich von 7 bis 11. Nach den Angaben in dieser Druckschrift wird Gold mit einer Geschwindigkeit von maximal 1 µm/Stunde auf Nickel-, Kobalt- und Goldschichten abgeschieden. Es wird erwähnt, daß die Abscheidegeschwindigkeit bei einem pH-Wert unterhalb von 7 zu gering sei.

In WO-A-92/00398 ist eine Kombination wäßriger Bäder zur stromlosen Goldabscheidung beschrieben. Das Vorbeschichtungsbad enthält Disulfitoaurat(I)-Komplexe, ein Alkali- oder Ammoniumsulfit als Stabilisator, ein Reduktionsmittel und einen weiteren Komplexbildner. Als Reduktionsmittel werden Aldehyde, beispielsweise Formaldehyd, oder deren Derivate und als weiterer Komplexbildner beispielsweise Ethylendiamin eingesetzt. In einem zweiten Bad sind neben Dicyanoaurat(I)-Komplexen Kobalt(II)-Salze und Thioharnstoff enthalten. Die Goldschichten werden wiederum auf Nickel- oder Nickellegierungsoberflächen abgeschieden. Das Vorbeschichtungsbad wird auf einen pH-Wert von höchstens 8 eingestellt.

In US-A-53 18 621 ist eine stromlose Metallabscheidelösung für Silber und Gold beschrieben, die einen nicht-cyanidischen Metallkomplex mit Thiosulfat, Sulfit und Ethylendiamintetraessigsäure als Komplexbildner und mindestens eine Aminosäure zur Erhöhung der Abscheidegeschwindigkeit enthält. Es werden Beispiele zur Bildung von Silberschichten auf mit Nickelschichten überzogenen Kupferoberflächen dargestellt. Die Lösungen weisen einen pH-Wert im Bereich von 7 bis 9 und vorzugsweise von 7,5 bis 8,5 auf.

In WO-A-92/02663 ist ein stabiles, stromloses, saures Goldbad beschrieben, das Tetracyanogold(III)-Komplexe, mindestens einen Carboxyl- und Phosphonsäuregruppen enthaltenden Komplexbildner und Säure enthält, wobei der pH-Wert der Lösung unter 1 eingestellt wird. Die Goldschichten werden beispielsweise auf Schichten aus Eisen/Nickel/Kobalt-Legierungen, Nickel- oder Wolframoberflächen mit einer Geschwindigkeit von 0,2 bis 0,5 µm in 30 Minuten abgeschieden.

In US-A-54 70 381 ist eine stromlose Goldabscheidelösung offenbart, die Tetrachlorogold(III)-Komplexe oder Gold(I)-Komplexe mit Thiosulfat oder Sulfit als Komplexbildner, ferner Ascorbinsäure, einen pH-Puffer und Schwefel enthaltende organische Verbindungen zur Stabilisierung der Lösung gegen Selbstzersetzung enthält. Die Lösung wird auf einen pH-Wert von 5 bis 9, vorzugsweise von 6 bis 8, eingestellt. Die Goldschichten werden auf ein Substrat aufgebracht, auf das zuerst eine 3 µm dicke Nickel- und danach eine ebenso dicke Goldschicht aufgebracht wurde. Die Abscheidungsgeschwindigkeit beträgt 0,6 bis 1 µm/Stunde.

Ein weiteres stromloses Goldabscheidebad wird in US-A-53 64 460 beschrieben, das einen Gold-Sulfito-Komplex und ein Reduktionsmittel aus der Gruppe Hydrazin, Ascorbinsäure, Trimethylamino- und Dimethylaminoboran enthält. Die Lösung enthält außerdem beispielsweise Aminosäuren oder Aminobenzoesäure zur Erhöhung der Abscheidungsgeschwindigkeit. Der pH-Wert der Lösung liegt im Bereich von 6 bis 11 und vorzugsweise von 7 bis 9. Die Abscheidungsgeschwindigkeit beträgt etwa 0,1 bis etwa 5 µm/Stunde. Es wird angegeben, daß sie bei einem pH-Wert unterhalb von 6 zu gering ist. Die Schichten werden auf Kupfer-, Nickel/Bor- oder Nickel/Phosphor-Schichten auf Leiterplatten oder keramischen Chipträgem abgeschieden.

Einige der bekannten Abscheidelösungen enthalten neben den Goldsalzen erhebliche Mengen Reduktionsmittel, wie beispielsweise Ascorbinsäure, Borane, Hydrazin oder Formaldehyd. Dies führt jedoch dazu, daß die Lösungen anfällig gegen die Ausfällung metallischen Goldes sind. Um die Stabilität der Lösungen gegen diese Selbstzersetzung zu verbessern, wurden verschiedene Anstrengungen unternommen: Beispielsweise wurden Schwefel enthaltende organische Verbindungen zur Lösung gegeben (US-A-54 70 381), oder es wurden nichtionische oberflächenaktive Stoffe oder Polymere als Stabilisatoren verwendet (US-A-53 64 460).

Allerdings hat sich herausgestellt, daß die Stabilisierung der reduktiven Goldbäder sehr schwierig ist. Selbst wenn durch einen Test, bei dem eine Ausfällung von Gold aus der Lösung untersucht wird, keine Instabilität festgestellt werden kann, kann Gold unter Umständen auf solchen Oberflächenbereichen, die für eine Goldabscheidung nicht katalytisch wirken sollen, trotzdem aufwachsen. Insbesondere bei der Herstellung feinststrukturierter elektronischer Bauteile bereitet dieser Wildwuchs Probleme, so daß auch geringste Stabilitätsprobleme sorgfältig zu vermeiden sind.

Daher sind auch Bäder entwickelt worden, in denen keine Reduktionsmittel enthalten sind. Derartige Bäder enthalten beispielsweise Thioharnstoff oder einen Komplexbildner, wie Ethylendiamintetraessigsäure oder deren Salze, um den Ladungsaustausch der Goldionen mit der unedleren Metallunterlage zu beschleunigen. Meist wird vorgeschlagen, Goldschichten auf Nickel- oder Nikkellegierungsoberflächen abzuscheiden.

Ein derartiges Bad ist in GB-A-1,022,061 beschrieben. Dieses Bad enthält ein Goldsalz sowie Ethylendiamintetraessigsäure als Komplexbildner und zusätzlich beispielsweise Nickel-, Kobalt- oder Kupferionen, die u.a. mit Salicylsäure komplex gebunden sind, um die Abscheidung dicker Goldschichten zu ermöglichen. Der pH-Wert des Bades beträgt mindestens 6,5 und ist damit für eine Beschichtung von mit Photoresisten oder einem Siebdrucklack beschichteten Substrat nicht geeignet. Die Goldschichten werden auf einer Nickelunterlage abgeschieden.

Bei der Goldabscheidung wird Nickel aufgelöst. Daher ist es sehr wichtig, den Goldabscheideprozeß nach einer bestimmten Zeit zu unterbrechen, um einen zu großen Nickelverlust durch Korrosion zu vermeiden. In diesem Falle könnte die niedergeschlagene Goldschicht den Kontakt zur darunter liegenden Goldschicht verlieren, so daß die Goldschicht abgehoben werden würde. Kommt es zu Goldabhebungen, so wird die Goldschicht für jede weitere Bearbeitung, beispielsweise Lötprozesse, wertlos.

Aus den genannten Gründen konnten sich die Endschichten aus Nickel bzw. einer Nickellegierung und einer darüber liegenden Goldschicht nur für Lötanwendungen sowie als Kontaktschicht zum Ultraschallbonden von integrierten Halbleiterschaltkreisen mit der Ultraschall-Bondtechnik durchsetzen. Für Thermosonic-Bondtechniken sind Nickel/Gold-Schichten jedoch nicht geeignet, da die erreichbare Schichtdicke nicht ausreicht. Für diesen Fall könnten zwar die zuvor erwähnten stromlosen Goldbäder eingesetzt werden, da mit diesen auch dickere Goldschichten hergestellt werden können. Derartige Bäder weisen jedoch die zuvor genannten Nachteile auf. Teilweise sind diese Bäder zudem alkalisch und können daher nicht für die Verarbeitung von mit Photo- und Siebdruckresisten versehenen Schaltungen eingesetzt werden.

Auch bei den auf einer Ladungsaustauschreaktion beruhenden Verfahren sind weitere Nachteile beobachtet worden. Selbst bei scheinbar intakten Schichtkombinationen mit Nickel- und Goldschichten wurde bei sehr gründlichen Untersuchungen festgestellt, daß zwar große Bereiche der Nickelschicht unbeeinträchtigt bleiben, während sich Nickel in lokal eng begrenzten Bereichen dagegen auflöst. An den Stellen, an denen die Nickelschicht stark angegriffen wird, kann deswegen kein Haftverbund mit der aufwachsenden Goldschicht gebildet werden. Besonders bei der Herstellung hochwertiger feinststrukturierter elektronischer Bauteile führt dies zwangsläufig zum Totalausfall der gesamten Schaltung, da derartige Fehler groß genug sein können, um eine gesamte Funktionsfläche auf der Schaltung unbrauchbar zu machen. Obwohl Bäder ohne Reduktionsmittel eine erhöhte Badstabilität aufweisen, sind sie für eine Anwendung bei der Herstellung feinststrukturierter elektronischer Bauteile daher nicht geeignet.

Der vorliegenden Erfindung liegt von daher das Problem zugrunde, die Nachteile der bekannten Verfahren zu vermeiden und insbesondere ein Verfahren und eine chemische Lösung zu finden, mit denen eine Metallisierung auch feinststrukturierter Metallbereiche für elektronische Bauteile möglich ist, wobei zum einen sicher vermieden wird, daß für die Goldabscheidung nicht katalytisch wirkende Bereiche vergoldet werden und bei dem zum anderen Probleme mit der Auflösung der metallischen Unterlage nicht auftreten. Ferner soll mit dem Verfahren auch die Herstellung von Endschichten auf Metallstrukturen möglich sein, die mittels eines Thermosonic-Verfahrens gebondet werden können.

Gelöst wird dieses Problem durch ein Verfahren nach Anspruch 1 und eine wäßrige Lösung nach Anspruch 9. Bevorzugte Ausführungsformen der Erfindung sind in den Unteransprüchen angegeben.

Das Prinzip des erfindungsgemäßen Verfahrens und der Lösung beruht auf einer katalytisch kontrollierten Abscheidung von Gold. Diese wird durch die Abscheidung insbesondere auf Palladiumoberflächen ermöglicht, wobei eine wäßrige Abscheidelösung verwendet wird, die mindestens eine Verbindung aus der Gruppe, bestehend aus Gold(I)- oder Gold(III)-lonen enthaltenden Verbindungen, mindestens eine organische Verbindung aus der Gruppe, bestehend aus Ameisensäure, aromatischen Carbonsäuren mit der chemischen Formel 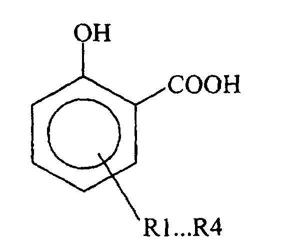 wobei R1...R4 = H, Alkyl, Alkenyl, Alkinyl, OH sind,
sowie Salzen, Estern oder Amiden dieser Verbindungen, enthält. Der pH-Wert der Lösung beträgt 1 bis 6. Die aromatischen Carbonsäuren können neben der Carbonsäure- und der ortho-ständigen Hydroxygruppe zusätzlich eine oder mehrere Gruppen R1 bis R4 enthalten. Als aromatische Carbonsäure ist Salicylsäure besonders gut geeignet.

Die Konzentration der erfindungsgemäßen organischen Verbindungen liegt vorzugsweise im Bereich von 0,001 bis 5 Mol/Liter und besonders bevorzugt von 0,005 bis 0,3 Mol/Liter.

Die Goldschichten werden vorzugsweise durch In-Kontakt-Bringen von zu beschichtenden Palladiumoberflächen mit der Goldabscheidelösung gebildet. Palladiumschichten können auf einfache Weise, vorzugsweise durch stromlose Abscheidung, hergestellt werden.

Das Verfahren weist verschiedene Vorteile auf:
1. Die Goldabscheidung findet ausschließlich auf den Palladiumschichten statt. Dadurch wird eine Goldabscheidung auf anderen Oberflächenbereichen des Werkstückes sicher vermieden.
2. Durch Verwendung der erfindungsgemäßen organischen Verbindungen aus der Gruppe, bestehend aus Ameisensäure, aromatischen Carbonsäuren sowie Salzen, Estern und Amiden dieser Verbindungen, können nicht nur dünne, sondern auch dickere Goldschichten abgeschieden werden. Es wird vermutet, daß diese Zusatzstoffe an den Palladiumoberflächen katalytisch zersetzt werden und das Reduktionsmittel für die Goldabscheidung liefern.
3. Aus demselben Grunde sind die Abscheidebäder sehr stabil gegen eine Selbstzersetzung, da nur katalytisch wirkendes Palladium zur Goldreduktion beiträgt.
4. Die Goldabscheidung wird nicht bereits bei Bildung von 0,2 µm dicken Schichten unterbrochen. Offensichtlich reichen auch kleinste Poren in der die Palladiumunterlage abdeckenden Goldschicht aus, um ein Weiterwachsen der Goldschicht zu ermöglichen. Daher kommt die Goldabscheidung erst bei Schichtdicken oberhalb von etwa 1 µm zum Erliegen.
5. Da der pH-Wert der Lösung im sauren Bereich eingestellt werden kann und somit die Metallisierungslösung auch alkalisch entwickelbare Foto- und Siebdruckresiste nicht angreift, können auch feinststrukturierte Metalloberflächen vergoldet werden. Dies hat den Vorteil, daß nicht die gesamte Fläche beispielsweise einer Leiterplatte mit Gold beschichtet werden muß. Es reicht aus, lediglich die für einen Bond- oder Lötprozeß benötigten Metallstrukturen zu vergolden, wobei vorzugsweise auch die Flanken der Metallstrukturen mitbeschichtet werden.

Es werden Goldschichten mit einer Dicke von 0,3 bis 0,8 µm abgeschieden. Auch dickere Schichten können erzeugt werden. Jedoch sind diese für die genannten Einsatzgebiete nicht erforderlich. Durch deren Bildung würden zu hohe Kosten verursacht werden.

Als Gold(I)-Verbindungen können Cyanokomplexe (Salze des Anions [Au(CN)₂]⁻) oder Sulfitokomplexe (Salze des Anions [Au(SO₃)₂]³⁻) eingesetzt werden. Als Gold(III)-Verbindungen werden ebenfalls vorzugsweise Cyanokomplexe (Salze des Anions [Au(CN)₄]⁻) oder Halogenokomplexe (Salze des Anions [AuX₄]⁻) sowie Goldhalogenide bzw. Goldcyanid (AuX₃) verwendet. X stellt hierbei ein Halogen, vorzugsweise Chlor, oder CN dar. Darüber hinaus können auch andere Verbindungen des Golds eingesetzt werden, beispielsweise Thiosulfatokomplexe.

Die Konzentration der Goldverbindungen liegt vorzugsweise im Bereich von 0,01 bis 20 g/Liter, bezogen auf den Goldgehalt. Eine besonders geeignete Lösung enthält die Goldverbindungen in einer Konzentration von etwa 2 g/Liter, bezogen auf den Goldgehalt.

Die Lösung kann ferner zusätzlich mindestens einen Komplexbildner für andere Metallionen, vornehmlich Schwermetallionen, beispielsweise Nickel-, Kobalt-, Kupfer-, Zinn-, Blei- oder Palladiumionen enthalten. Als Komplexbildner werden unter anderem Aminosäuren, beispielsweise β-Alanindiessigsäure 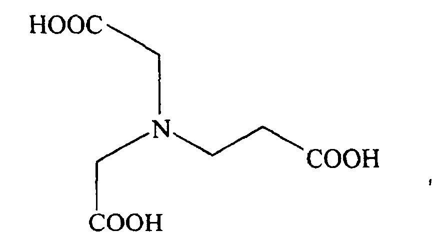 oder deren Salze verwendet. Auch die erfindungsgemäßen Carbonsäuren bzw. deren Salze können gegebenenfalls als Komplexbildner für die genannten Schwermetallkationen wirken.

Zur Einstellung des pH-Wertes der Lösung dienen vorzugsweise Säuren, beispielsweise Schwefelsäure oder Sulfonsäuren. Unter anderem können Methan-, Benzol-, Toluol- oder Phenolsulfonsäure verwendet werden. Auch Salzsäure kann zum Einstellen des pH-Wertes dienen, vor allem wenn ein Chlorokomplex von Gold verwendet wird.

Neben den genannten Badkomponenten kann die Beschichtungslösung auch den pH-Wert puffernde Substanzen enthalten, beispielsweise einen Citrat- oder Acetatpuffer. Ferner kann die Goldlösung auch weitere Substanzen enthalten.

Die Temperatur der Beschichtungslösung wird je nach der gewählten Badzusammensetzung eingestellt. Als besonders geeignet hat sich eine Temperatur im Bereich von 65 bis 95°C herausgestellt.

Zur Herstellung von elektrischen Schaltungen, beispielsweise von Leiterplatten, oder Schaltungsträgern für Halbleiterschaltungen, werden üblicherweise aus Kupfer bestehende Metallstrukturen erzeugt, die zur Bildung der Goldschichten mit dem erfindungsgemäßen Verfahren zuerst mit Palladiumschichten überzogen werden.

Die Palladiumschichten können durch elektrolytisches oder stromloses Abscheiden aus einer geeigneten Beschichtungslösung gebildet werden. Vorzugsweise kommen hierzu formaldehydfreie Palladiumbäder in Betracht. Besonders geeignet sind Bäder, die als Reduktionsmittel Ameisensäure, deren Salze und/oder Ester enthalten. Derartige Bäder enthalten ferner ein Palladiumsalz und einen oder mehrere stickstoffhaltige Komplexbildner. Der pH-Wert dieser Bäder liegt oberhalb von 4, vorzugsweise im Bereich von 5 bis 6. Als Palladiumsalze können beliebige Palladiumverbindungen einsetzt werden, beispielsweise Palladiumchlorid, Palladiumsulfat, Palladiumnitrat oder Palladiumacetat. Als stickstoffhaltige Komplexbildner werden beispielsweise Ethylendiamin, 1,3-Diaminopropan, 1,2-Bis-(3-aminopropylamino)-ethan, 2-Diethylaminoethylamin und Diethylentriamin verwendet.

Andere stromlose Palladiumbeschichtungslösungen enthalten neben-einer Palladiumverbindung beispielsweise ein Amin oder Ammoniak, eine Schwefel enthaltende Verbindung und hypophosphorige Säure oder deren Salze als Reduktionsmittel.

Die Palladiumschicht wird entweder direkt auf elektrolytisch oder stromlos gebildete Nickel- oder Kobalt enthaltende Schichten abgeschieden, beispielsweise eine Nickel/Bor- oder eine Kobalt/Phosphor-Legierungsschicht. Falls eine Kupferoberfläche vorliegt, kann die Palladiumschicht auch auf eine mittels Ladungsaustausch gebildete dünne Palladiumschicht aufgetragen werden.

Elektrisch nichtleitende Oberflächen können mit einem üblichen Palladiumaktivator bekeimt und anschließend mit einem stromlosen Palladiumbad palladiniert werden, wenn sie mit einer Goldendschicht versehen werden sollen.

Die Beschichtung mit Gold und gegebenenfalls auch mit den anderen Beschichtungsmetallen Palladium, Nickel, Kobalt und Kupfer kann in üblichen Tauchanlagen durchgeführt werden. Anstelle eines Tauchprozesses kann jedoch auch eine Beschichtungsmethode angewandt werden, bei der die Werkstücke mit den Lösungen über Sprüh-, Schwall- oder Spritzstrahlen in Kontakt gebracht werden. Eine bevorzugte Verfahrensweise besteht darin, Leiterplatten in horizontaler Richtung und in horizontaler oder vertikaler Lage durch eine Behandlungsanlage hindurchzuführen und die Beschichtungslösungen hierbei sukzessive über Sprüh-, Schwall- oder Spritzdüsen an die Leiterplattenoberflächen heranzuführen.

Mit dem erfindungsgemäßen Verfahren können feinststrukturierte Schaltungsträger mit oberflächenmontierten Halbleiterschaltkreisen hergestellt werden, bei denen die Schaltkreise über Ball-wegde-Bonds mit korrespondierenden Anschlußplätzen auf dem Schaltungsträger verbunden sind. Derartige Ball-wedge-Bonds können mit dem Thermosonic-Verfahren erzeugt werden.

Die nachfolgenden Beispiele dienen zur weiteren Erläuterung der Erfindung:

### Beispiel 1:

Ein mit einer Kupferschicht kaschiertes Basismaterial für Leiterplatten aus Epoxidharz/Glasfasergewebe (FR4) wurde mit einer weiteren 30 µm dicken Kupferschicht mittels elektrolytischer Kupferabscheidung aus einem üblichen schwefelsauren Kupferbad versehen.

Anschließend wurde eine Schichtkombination von 5 µm Nickel und danach 5 µm Gold jeweils elektrolytisch abgeschieden. Die hierfür verwendeten Bäder sind handelsüblich. Danach wurde eine 0,5 µm dicke Palladiumschicht aus einem Bad zur stromlosen Palladinierung aufgebracht. Das Bad enthielt folgende Badbestandteile:

| | |
|---|---|
| Palladiumacetat | 0,05 Mol/Liter |
| Ethylendiamin | 0,1 Mol/Liter |
| Natriumformiat | 0,2 Mol/Liter |
| Bernsteinsäure | 0,15 Mol/Liter. |

Der pH-Wert des Bades wurde mit Ameisensäure auf 5,5 eingestellt. Die Badtemperatur betrug 67°C.

Anschließend wurde die Platte in eine wäßrige Lösung mit der folgenden Zusammensetzung eingetaucht:

| | |
|---|---|
| Natriumgold(I)-cyanid | 3 g/Liter |
| Natriumformiat | 20 g/Liter |
| β-Alanindiessigsäure | 20 g/Liter |
| pH-Wert | 3,5 |
| Temperatur | 89°C. |

Nach 1 Stunde war eine Goldschicht mit einer Dicke von 0,6 µm auf dem Palladium abgeschieden. Die Schicht haftete fest auf der Unterlage. Bei einer Untersuchung der unter der Goldschicht liegenden Metallschichten konnte festgestellt werden, daß die Metallschichten unverändert und insbesondere nicht korrodiert waren.

### Beispiel 2:

Kupferleiterbahnen einer Leiterplatte wurden mittels eines üblichen stromlosen Beschichtungsbades mit einer 5 µm dicken Nickel/Phosphor-Schicht versehen. Anschließend wurden die Nickelschichten mit einer 0,5 µm dicken Palladiumschicht überzogen. Danach wurde die Leiterplatte 5 Minuten lang in ein wäßriges Bad mit der folgenden Zusammensetzung eingetaucht:

| | |
|---|---|
| Natriumgold(I)-cyanid | 2 g/Liter |
| Salicylsäure | (Lösung gesättigt mit Salicylsäure) |
| β-Alanindiessigsäure | 20 g/Liter |
| pH-Wert | 2,5 |
| Temperatur | 89°C. |

Die Oberflächen der Leiterbahnen wiesen eine goldfarbene Oberfläche auf. Die Dicke der Goldschicht betrug 0,08 µm. In einer Querschliff-Untersuchung der Schichtkombination konnte keine Korrosion der Basismetallschichten entdeckt werden. Die Haftung der Goldschicht auf der Unterlage war hervorragend.

### Beispiel 3:

Eine Leiterplatte wurde wie in Beispiel 2 vorbereitet und anschließend in eine wäßrige Lösung mit folgender Zusammensetzung eingetaucht:

| | |
|---|---|
| Kaliumgold(III)-cyanid | 3 g/Liter |
| Phenolsulfonsäure | 15 g/Liter |
| Ameisensäure | 10 g/Liter |
| pH-Wert | 1 |
| Temperatur | 70°C. |

Nach einer Beschichtungszeit von 20 Minuten war eine 0,37 µm dicke Goldschicht abgeschieden, die wiederum sehr fest auf der Unterlage haftete. Eine Korrosion der Grundmetalle konnte im Querschliffbild nicht beobachtet werden.

### Beispiel 4:

Mittels üblicher Ätzmittel aufgerauhtes FR4-Laminat mit einer Harzoberfläche wurde mit einem handelsüblichen Palladiumaktivator (Adsorption eines Pd-Komplexes aus wäßriger Lösung und anschließende Reduktion des Komplexes auf der FR4-Oberfläche) behandelt.

Anschließend wurde eine 0,5 µm dicke Palladiumschicht abgeschieden. Das Laminat wurde danach 20 Minuten lang in ein Goldbad mit der Zusammensetzung gemäß Beispiel 2 eingetaucht.

Es wurde eine 0,3 µm dicke festhaftende Goldschicht abgeschieden.

### Beispiel 5:

Ein gemäß Beispiel 4 vorbehandeltes Laminat wurde mit einer 0,5 µm dicken Palladiumschicht überzogen. Anschließend wurde eine 0,1 µm dicke, festhaftende Goldschicht abgeschieden, indem das Laminat in ein Bad mit folgender Zusammensetzung eingetaucht wurde:

| | |
|---|---|
| Gold(III)-chlorid | 1,5 g/Liter |
| Natriumformiat | 20 g/Liter |
| pH-Wert | 3,5 |
| Temperatur | 70°C. |

### Vergleichsbeispiel 1:

Beispiel 1 wurde wiederholt. Allerdings wurde auf der elektrolytisch aufgebrachten Kupferschicht nur eine Nickelschicht abgeschieden, nicht jedoch zusätzlich eine Gold- und eine Palladiumschicht.

Auf der Nickelschicht wurde die Goldschicht aus dem erfindungsgemäßen Bad direkt niedergeschlagen.

Die Haftfestigkeit der Goldschicht war wesentlich schlechter als gemäß Beispiel 1, da die Nickelschicht stark korrodierte und sich die Goldschicht daher flitterartig von der Unterlage ablöste.

### Vergleichsbeispiel 2:

Beispiel 1 wurde wiederholt. Allerdings wurde die Goldschicht auf die elektrolytisch aufgebrachte Kupferschicht ohne weitere Zwischenschichten direkt abgeschieden. Die Kupferschicht korrodierte stark. Durch die Auflösung von Kupfer im Goldbad wurde die Goldabscheidung inhibiert. Die Abscheidungsgeschwindigkeit verlangsamte sich schnell, bis der Prozeß zum Stillstand kam.

### Vergleichsbeispiel 3:

Beispiel 3 wurde wiederholt Anstelle der in Beispiel 3 angegebenen Zusammensetzung für das Goldbad wurde jedoch eine Zusammensetzung gewählt, bei der keine Ameisensäure verwendet wurde.

Es konnte keine Goldabscheidung beobachtet werden.

## Patentansprüche

1. Verfahren zur Herstellung von Goldschichten auf einem eine Palladiumoberfläche aufweisenden Werkstück, bei dem
a. eine wäßrige Lösung, enthaltend
i. mindestens eine Verbindung aus der Gruppe, bestehend aus Gold(I)- oder Gold(III)-lonen enthaltenden Verbindungen, und
ii. zusätzlich mindestens eine organische Verbindung aus der Gruppe, bestehend aus Ameisensäure, aromatischen Carbonsäuren mit der chemischen Formel 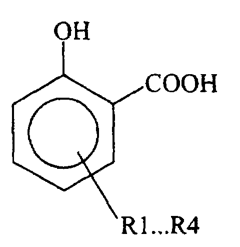 wobei R1...R4 = H, Alkyl, Alkenyl, Alkinyl, OH sind,
sowie Salzen, Estern oder Amiden dieser Verbindungen, verwendet wird,
b. die Lösung mit pH-Einstellmitteln auf einen pH-Wert von 1 bis 6 eingestellt wird und
c. das Werkstück mit der Lösung in Kontakt gebracht wird.

2. Verfahren nach Anspruch 1, **dadurch gekennzeichnet, daß** als aromatische Carbonsäure Salicylsäure verwendet wird.

3. Verfahren nach einem der vorstehenden Ansprüche, **dadurch gekennzeichnet, daß** die Lösung auf einen pH-Wert von 3 bis 3,5 eingestellt wird.

4. Verfahren nach einem der vorstehenden Ansprüche, **dadurch gekennzeichnet, daß** die Palladiumoberfläche durch elektrolytische oder stromlose Abscheidung von Palladiumschichten gebildet wird.

5. Verfahren nach Anspruch 4, **dadurch gekennzeichnet, daß** die Palladiumschichten auf elektrolytisch oder stromlos abgeschiedene Nickel oder Kobalt enthaltende Schichten auf dem Werkstück abgeschieden werden.

6. Verfahren nach Anspruch 4, **dadurch gekennzeichnet, daß** die Palladiumschichten nach vorausgegangener Aktivierung auf elektrisch nichtleitenden Oberflächen des Werkstückes abgeschieden werden.

7. Verfahren nach einem der vorstehenden Ansprüche, **dadurch gekennzeichnet, daß** zur wäßrigen Lösung zusätzlich mindestens ein Komplexbildner für Metallionen, ausgewählt aus der Gruppe, bestehend aus Nickel-, Kobalt-, Kupfer-, Zinn-, Blei- und Palladiumionen, zugegeben wird.

8. Verfahren nach einem der vorstehenden Ansprüche, **dadurch gekennzeichnet, daß** als Gold(I)-lonen enthaltende Verbindungen Salze der Anionen [Au(CN)₂]⁻ und/oder [Au(SO₃)₂]³⁻ und als Gold(III)-lonen enthaltende Verbindungen Salze der Anionen [AuX₄]⁻ und/oder AuX₃ verwendet werden, wobei X = F, Cl, Br, J oder CN ist.

9. Wäßrige Lösung zum Herstellen von Goldschichten auf einem Werkstück, enthaltend mindestens eine Verbindung aus der Gruppe, bestehend aus Gold(I)- oder Gold(III)-lonen enthaltenden Verbindungen, mit einem pH-Wert von 1 bis 6,
**dadurch gekennzeichnet, daß** die Lösung zusätzlich mindestens eine organische Verbindung aus der Gruppe, bestehend aus Ameisensäure, aromatischen Carbonsäuren mit der chemischen Formel 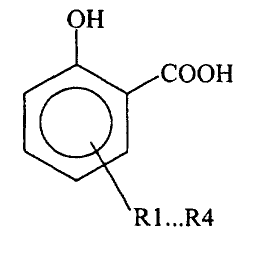 wobei R1...R4 = H, Alkyl, Alkenyl, Alkinyl, OH sind, sowie Salzen, Estern oder Amiden dieser Verbindungen enthält.

10. Lösung nach Anspruch 9, **gekennzeichnet durch** Salicylsäure als aromatische Carbonsäure.

11. Lösung nach einem der Ansprüche 9 und 10, **dadurch gekennzeichnet, daß** die Lösung einen pH-Wert von 3 bis 3,5 aufweist.

12. Lösung nach einem der Ansprüche 9 bis 11, **dadurch gekennzeichnet, daß** die Lösung mindestens einen zusätzlich enthaltenen Komplexbildner für Metallionen, ausgewählt aus der Gruppe, bestehend aus Nickel-, Kobalt-, Kupfer-, Zinn-, Blei- und Palladiumionen, enthält.

13. Lösung nach einem der Ansprüche 9 bis 12, **dadurch gekennzeichnet, daß** als Gold(I)-lonen enthaltende Verbindungen Salze der Anionen [Au(CN)₂]⁻ und/oder [Au(SO₃)₂]³⁻ und als Gold(III)-lonen enthaltende Verbindungen Salze der Anionen [AuX₄]⁻ und/oder AuX₃ enthalten sind, wobei X = F, Cl, Br, J oder CN ist.

## Claims

1. Method of producing gold layers on a workpiece which has one palladium surface, wherein
a. an aqueous solution is used, which contains
i. at least one compound from the group comprising compounds which contain gold(I) or gold(III) ions, and
ii. additionally at least one organic compound from the group comprising formic acid, aromatic carboxylic acids having the chemical formula 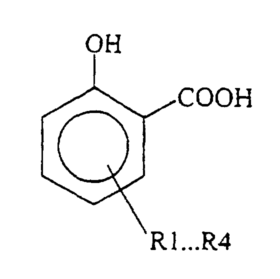 in which R1...R4 are H, alkyl, alkenyl, alkinyl and OH,
and salts, esters or amides of these compounds,
b. the solution is set to a pH value of 1 to 6 by pH setting agents, and
c. the workpiece is brought into contact with the solution.

2. Method according to claim 1, **characterised in that** salicylic acid is used as the aromatic carboxylic acid.

3. Method according to one of the preceding claims, **characterised in that** the solution is set to a pH value of 3 to 3.5.

4. Method according to one of the preceding claims, **characterised in that** the palladium surface is formed by the electrolytic or currentless deposition of palladium layers.

5. Method according to claim 4, **characterised in that** the palladium layers are deposited on electrolytically or currentlessly deposited layers, which contain nickel or cobalt, on the workpiece.

6. Method according to claim 4, **characterised in that**, after previous activation, the palladium layers are deposited on electrically nonconductive surfaces of the workpiece.

7. Method according to one of the preceding claims, **characterised in that** at least one complexing agent for metal ions, selected from the group comprising nickel, cobalt, copper, tin, lead and palladium ions, is additionally added to the aqueous solution.

8. Method according to one of the preceding claims, **characterised in that** salts of the anions [Au(CN)₂]⁻ and/or [Au(SO₃)₂]³⁻ are used as the compounds containing gold(I) ions, and salts of the anions [AuX₄]⁻ and/or AuX₃ are used as the compounds containing gold(III) ions, X being F, Cl, Br, I or CN.

9. Aqueous solution for producing gold layers on a workpiece, containing at least one compound from the group comprising compounds which contain gold(I) or gold(III) ions, with a pH value of 1 to 6, **characterised in that** the solution additionally contains at least one organic compound from the group comprising formic acid, aromatic carboxylic acids having the chemical formula 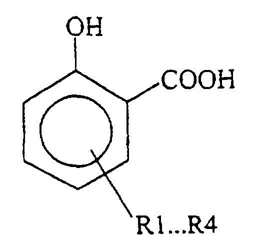 in which R1...R4 are H, alkyl, alkenyl, alkinyl and OH,
and salts, esters or amides of these compounds.

10. Solution according to claim 9, **characterised by** salicylic acid as the aromatic carboxylic acid.

11. Solution according to one of claims 9 and 10, **characterised in that** the solution has a pH value of 3 to 3.5.

12. Solution according to one of claims 9 to 11, **characterised in that** the solution contains at least one additionally contained complexing agent for metal ions, selected from the group comprising nickel, cobalt, copper, tin, lead and palladium ions.

13. Solution according to one of claims 9 to 12, **characterised in that** salts of the anions [Au(CN)₂]⁻ and/or [Au(SO₃)₂]³⁻ are contained as the compounds containing gold(I) ions, and salts of the anions [AuX₄]⁻ and/or AuX₃ are contained as the compounds containing gold(III) ions, X being F, Cl, Br, I or CN.

## Revendications

1. Procédé pour produire des couches d'or sur une pièce d'oeuvre présentant une surface en palladium, dans lequel
a. on utilise une solution aqueuse, comprenant
i. au moins un composé du groupe constitué par les composés contenant des ions or (I) ou or (III), et
ii. au moins en plus un composé organique du groupe constitué par l'acide formique, les acides carboxyliques aromatiques de formule chimique : 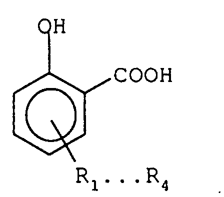 dans laquelle R1...R4 = H, alkyle, alcènyle, alcinyle, OH,
ainsi que des sels, esters et amides de ces composés,
b. on ajuste la solution à un pH situé entre 1 et 6 avec un agent de réglage du pH et
c. la pièce d'oeuvre est mise en contact avec la solution.

2. Procédé selon la revendication 1, **caractérisé en ce qu'**on utilise l'acide salicylique comme acide carboxylique.

3. Procédé selon l'une des revendications précédentes, **caractérisé en ce que** la solution est ajustée à un pH situé entre 3 et 3,5.

4. Procédé selon l'une des revendications précédentes, **caractérisé en ce que** la surface en palladium est formée par précipitation électrolytique ou autocatalytique de couches de palladium.

5. Procédé selon la revendication 4, **caractérisé en ce que** les couches de palladium sont précipitées sur la pièce d'oeuvre sur des couches contenant du cobalt ou du nickel précipitées életrolytiquement ou autocatalytiquement.

6. Procédé selon la revendication 4, **caractérisé en ce que** les couches de palladium sont précipitées sur des surfaces de la pièce d'oeuvre non conductrices d'électricité après une activation préalable.

7. Procédé selon l'une des revendications précédentes, **caractérisé en ce qu'**on ajoute à la solution aqueuse au moins en plus un agent complexant pour ions métalliques, choisis parmi le groupe constitué par les ions nickel, cobalt, cuivre, étain, plomb et palladium.

8. Procédé selon l'une des revendications précédentes, **caractérisé en ce qu'**on utilise des sels d'anions [Au(CN)₂]⁻ et/ou [Au(SO₃)₂]³⁻ comme composés contenant des ions or (I) et des sels d'anions [AuX₄]⁻ et/ou AuX₃ comme composés contenant des ions (III), où X = F, Cl, Br, J ou CN.

9. Solution aqueuse pour produire des couches d'or sur une pièce d'oeuvre, contenant au moins un composé du groupe constitué par les composés contenant des ions or (I) ou or (III) de pH situé entre 1 et 6,
**caractérisée en ce que** la solution contient au moins en plus un composé organique du groupe constitué par l'acide formique, les acides carboxyliques aromatiques de formule chimique 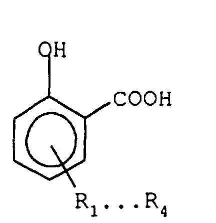 dans laquelle R1...R4 = H, alkyle, alcènyle, alcinyle, OH,
ainsi que des sels, esters ou amides de ces composés.

10. Solution selon la revendication 9, **caractérisée en ce qu'**on utilise l'acide salicylique comme acide carboxylique aromatique.

11. Solution selon l'une des revendications 9 et 10, **caractérisée en ce que** la solution présente un pH situé entre 3 et 3,5.

12. Solution selon l'une des revendications 9 à 11, **caractérisée en ce que** la solution contient au moins un agent complexant supplémentaire pour ions métalliques choisis parmi le groupe constitué par les ions, nickel, cobalt, cuivre, étain, plomb et palladium.

13. Solution selon l'une des revendications 9 à 12, **caractérisée en ce qu'**on utilise des sels d'anions [Au(CN)₂]⁻ et/ou [Au(SO₃)₂]³⁻ comme composés contenant des ions or (I) et des sels d'anions [AuX₄]⁻ et/ou AuX₃ comme composés contenant des ions (III), où X = F, Cl, Br, J ou CN.
